# EUROPEAN PATENT APPLICATION

(11) **EP 4 494 771 A1**
(43) Date of publication of application: **22.01.2025**
(21) Application number: 24192083.4
(22) Date of filing: 31.05.2017
(51) Int. Cl.: B05D 3/06, B05D 1/00, B26B 21/60, C23C 14/12, C23C 14/28, B05D 5/08, B05D 3/02, B05D 3/04

(54) **PULSED LASER DEPOSITION OF FLUOROCARBON POLYMERS ON RAZOR BLADE CUTTING EDGES**

(30) Priority: 31.05.2016 US 201662343333 P
(62) Divisional of application: 17729315.6
(71) Applicant: Edgewell Personal Care Brands, LLC, Chesterfield MO 63017 (US)
(72) Inventor: Camphausen, Scott, Cennecticut, 06460 (US); Nall, Jonathanus, Tennessee, 37914 (US); Nicolosi, Randy, Connecticut, 06484 (US)
(74) Representative: dompatent von Kreisler Selting Werner - Partnerschaft von Patent- und Rechtsanwälten mbB

(57) **Abstract**

The present invention relates to a process for forming a thin film of polytetrafluoroethylene on a substrate having multiple facets. The method comprises the following steps:
providing a polytetrafluoroethylene target, wherein said target is doped with graphite;
positioning the substrate proximate to the polytetrafluoroethylene target in a vacuum chamber at a pressure of 1.333×10⁻² Pascal to 1.333×10⁻⁴ Pascal;
irradiating the polytetrafluoroethylene target at a wavelength of 240 nm to 360 nm for a pulse length of 100 femtosecond to 500 picoseconds, at an intensity of 1 microjoule to 100 microjoules per pulse length, at a repetition rate of from 1 kHz to 10 Hz, for a time sufficient to deposit a polytetrafluoroethylene film on the substrate; and
forming a substantially uniform polytetrafluoroethylene thin film on one more facets of the substrate, wherein the film has a thickness of less than 100 nm.

## Description

The present invention provides a method for depositing a thin, substantially uniform PTFE coating on a multi-faceted substrate. Thins films of less than 300 nm, less than 100 nm, and less than 50 nm can be deposited with pulsed laser deposition (PLD) using lasers at wavelengths of 190 nm to 1075 nm on substrates having multi-facets such as a sharpened cutting edge. Such coatings are particularly useful on razor blade cutting edges to reduce the friction and lower cutting forces for an improved shave experience.

### BACKGROUND

Uncoated razor blades are not typically used for shaving a dry skin surface, e.g., a dry beard or other parts of the body, due to discomfort and pain, and it is common to soften the beard or hairs to be cut with water, shaving cream, and/or soap prior to shaving. Even so, irritation from shaving with uncoated blades is still encountered due to tugging and pulling as the blade passes through the hair. Blade coatings have therefore been developed to reduce the cutting force required to pass the blade through the hairs and reduce the discomfort cause by excessive tugging.

For many years, razor blade edges have been coated with fluorocarbon polymers, typically some form of polytetrafluoroethylene (PTFE), to improve shaving comfort. PTFE is typically sprayed on as a dispersion of PTFE particles with a surfactant in either water or other suitable carrier. The resulting coating is heated in an inert environment to melt the polymer to smooth the layer and bond it to the blade surface. However, the resulting coating tends to be too thick for optimum comfort, especially during the first shave. The act of shaving sloughs off the excess PTFE producing a more optimum shave performance. Therefore, the first shave can be less comfortable than succeeding shaves.

Attempts have been made to partially remove the PTFE layer, using solvents to remove excess PTFE, to produce a thinner coating and improve the comfort of the first shave. However, there are drawbacks to these methods as suitable solvents for PTFE are extremely expensive, have a limited useful life, and are difficult to dispose of properly. Alternatively, there have been attempts to form a thinner PTFE coating on the razor blades to provide that first shave comfort without the need to remove any excess PTFE.

U.S. Patent No. 5,985,459 discloses methods comprising treating polyfluorocarbon coated razor blade cutting edges with a solvent to thin the layer of PTFE thereby lowering initial cutting forces of the coated blade. Similarly, U.S. Patent Application No. 20160001456 further discloses applying a second polyfluorocarbon coating to the blade after the initial solvent treatment, optionally followed by a second solvent treatment. In both cases the coated blade is heated to adhere the polyfluorocarbon to the blade. U.S. Patent No. 9,027,443 discloses a razor containing at least two coated blades, wherein a first blade has a different frictional resistance than a second blade due to one blade having a different configuration of polymer coating than the other. Methods for modifying the coating of a coated razor blade are provided comprising exposing the coated blade to at least one of plasma, electric current or electron beam. A method for coating a blade by exposing it to a CF₂ containing plasma is also disclosed.

Infrared-laser deposition of TEFLON^{®} coatings on microstructures, M. R. Papantonakis and R. F. Haglund, Jr., Reliability, Packaging, Testing, and Characterization of MEMS/MOEMS V, edited by Danelle M. Tanner, Rajeshuni Ramesham, Proc. of SPIE Vol. 6111, 611104, (2006) discloses the use of a mid-IR laser, i.e., a laser emitting at wavelengths of from 2-10 microns, in the pulsed laser deposition of PTFE films on NaCl plates, silicon wafers, and a quartz crystal microbalance sensor, via ablation of TEFLON disks cut from a commercially available PTFE rod and pressed PTFE powder pellets. Also discussed were various challenges encountered when attempting to deposit high quality TEFLON thin films on microstructures, one of which is said to be the difficulty in obtaining suitable commercially available mid-IR lasers. Other difficulties include the formation of uniform PTFE films that are deficient in fluorine resulting from plasma polymerization of fluorocarbon monomers, ion beam and radio frequency sputtering, and polymer degradation that has been observed during UV or near-IR pulsed laser deposition of TEFLON resulting in monomers requiring heating at high-temperature to reform the polymer.

There remains a need for an improved process for consistently and efficiently forming high quality, low friction, and uniform thin films of fluorocarbon polymers on substrates such as razor blades and the like that are multi-faceted and less two dimensional than a plate or semiconductor wafer. Although, polymer degradation, i.e., carbon bond scission, typically occurs during UV or near-IR pulsed laser deposition of PTFE, it has been found that by controlling the intensity, pulse length and rate of pulse repetition, thin PTFE films with a substantially uniform thickness and excellent friction reduction and other high performance characteristics can be formed via pulsed laser deposition using lasers at wavelengths ranging from 190 to 1100 nm, i.e., UV through near IR. Due to the very thin and uniform nature and excellent adherence of the resulting films, multi-faceted surfaces such as cutting edges on razor blades, can be coated with uniform films having a thickness less than, e.g., 100 nm.

The method of the present invention is therefore highly suited for applying very thin uniform fluorocarbon polymer coatings, for example, PTFE coatings, on substrates, particularly those having at least one sharp cutting edge, which coating, when applied to the cutting edge of a razor blade, provides a blade exhibiting optimum performance and comfort from the first shave and for the life of the blade.

### SUMMARY

The present invention is direct to, in a first aspect, a process for forming a fluorocarbon polymer film on a substrate having one or more cutting edges defined by a sharpened tip and adjacent facets comprising the steps of: (i) providing a target comprising fluorocarbon polymer in a reaction chamber; (ii) positioning a substrate to be coated proximate to the target in the reaction chamber; (iii) establishing a vacuum pressure of 1.333×10⁻¹ Pascal to 1.333×10⁻⁷ Pascal inside the chamber; (iv) irradiating the fluorocarbon polymer target at a wavelength of 200 nm to 1100 nm for a pulse length of 100 femtosecond to 10 nanoseconds, at an intensity of 1 microjoule to 1 millijoule per pulse length, at a repetition rate of from 100 kHz to 1 GHz, for a time sufficient to deposit a fluorocarbon polymer film on the substrate; and (v) forming a substantially uniform fluorocarbon polymer thin film on at least the sharpened tip and a portion proximate to said sharpened tip of at least one facet of at least one cutting edge of the substrate.

Preferably, in the step of positioning the substrate to be coated proximate to a target comprising fluorocarbon polymer in a reaction chamber, the fluorocarbon polymer comprises polytetrafluoroethylene. Preferably, in the step of positioning the substrate to be coated proximate to a target comprising fluorocarbon polymer in a reaction chamber, the reaction chamber is at a pressure of from 1.333×10⁻² Pascal to 1.333×10⁻⁴ Pascal. One of ordinary skill in the art may also heat the substrate up to a temperature of 170°C. Preferably, in the step of irradiating the fluorocarbon polymer target, the pulse length is 1 femtosecond to 500 picoseconds. The process can form substantially uniform fluorocarbon polymer thin film, the film having a thickness of 10 nm to 100 nm. Most preferably, films formed have a thickness of 10 nm to 50 nm.

The process may further include the step of thermally processing the coated substrate after the step of forming the substantially uniform fluorocarbon polymer thin film. Preferably, the step of thermally processing the coated substrate comprises heating the substrate at temperatures of from 250 to 350°C for several minutes. The process may further include the step of providing an additional target comprising fluorocarbon polymer.

In yet another aspect, the present invention is directed to a process for forming a thin film of polytetrafluoroethylene on a substrate having multiple facets comprising the steps of: (i) providing a polytetrafluoroethylene target, said target doped with graphite; (ii) positioning the substrate proximate to the polytetrafluoroethylene target in a vacuum chamber at a pressure of 1.333×10⁻² Pascal to 1.333×10⁻⁴ Pascal; (iii) irradiating the polytetrafluoroethylene target at a wavelength of 240 nm to 360 nm for a pulse length of 100 femtosecond to 500 picoseconds, at an intensity of 1 microjoules to 250 millijoules per pulse length, at a repetition rate of from 1 kHz to 10 Hz, for a time sufficient to deposit a polytetrafluoroethylene film on the substrate; (vi) forming a substantially uniform polytetrafluoroethylene thin film on one more facets of the substrate wherein the film has a thickness of less than 100 nm; and (v) heating the substrate for a time and temperature to bond the polytetrafluoroethylene film to the substrate surface. The process may further include the step of heating the substrate in the vacuum chamber during deposition.

Preferably, the step of irradiating the polytetrafluoroethylene target occurs at a wavelength of 244 nm to 343 nm for 100 femtoseconds to 300 femtoseconds, at an intensity of 10 microjoules to 250 millijoules, at a repetition of 1 kHz to 500 kHz. Preferably, in the step of forming a substantially uniform polytetrafluoroethylene thin film, the film has a thickness of less than 50 nm.

In still yet another aspect, the present invention is further directed to a razor comprising a least one razor blade having a coating formed by any method of disclosed herein.

The present invention further comprises the following aspects:
Aspect 1:
   A process for forming a fluorocarbon polymer film on a substrate having one or more cutting edges defined by a sharpened tip and adjacent facets comprising the steps of:
   providing a target comprising fluorocarbon polymer in a reaction chamber;
   positioning a substrate to be coated proximate to the target in the reaction chamber;
   establishing a vacuum pressure of 1.333×10⁻¹ Pascal to 1.333×10⁻⁷ Pascal inside the chamber;
      irradiating the fluorocarbon polymer target at a wavelength of 200 nm to 1100 nm for a pulse length of 100 femtosecond to 10 nanoseconds, at an intensity of 1 microjoule to 250 millijoules per pulse length, at a repetition rate of from 100 kHz to 1 GHz, for a time sufficient to deposit a fluorocarbon polymer film on the substrate; and
   forming a substantially uniform fluorocarbon polymer thin film on at least the sharpened tip and a portion proximate to said sharpened tip of at least one facet of at least one cutting edge of the substrate.
Aspect 2:
   The process according to aspect 1 wherein in the step of positioning the substrate to be coated proximate to a target comprising fluorocarbon polymer in a reaction chamber, the fluorocarbon polymer comprises polytetrafluoroethylene.
Aspect 3:
   The process according to aspect 1 wherein in the step of positioning the substrate to be coated proximate to a target comprising fluorocarbon polymer in a reaction chamber, the reaction chamber is at a pressure of from 1.333×10⁻² Pascal to 1.333×10⁻⁴ Pascal.
Aspect 4:
   The process according to any preceding aspect further including the step of heating the substrate up to a temperature of 170° C.
Aspect 5:
   The process according to any preceding aspect wherein in the step of irradiating the fluorocarbon polymer target, the pulse length is 1 femtosecond to 500 picoseconds.
Aspect 6:
   The process according to any preceding aspect wherein in the step of forming the substantially uniform fluorocarbon polymer thin film, the film has a thickness of 10 nm to 100 nm.
Aspect 7:
   The process according to aspect 8 wherein in the step of forming the substantially uniform fluorocarbon polymer thin film, the film has a thickness of 10 nm to 50 nm.
Aspect 8:
   The process according to any preceding aspect further including the step of thermally processing the coated substrate after the step of forming the substantially uniform fluorocarbon polymer thin film.
Aspect 9:
   The process according to aspect 8 wherein the step of thermally processing the coated substrate comprises heating the substrate at temperatures of from 250 to 350° C for several minutes.
Aspect 10:
   The process according to any preceding claim further including the step of providing an additional target comprising fluorocarbon polymer.
Aspect 11:
   A process for forming a thin film of polytetrafluoroethylene on a substrate having multiple facets comprising the steps of:
   providing a polytetrafluoroethylene target, said target doped with graphite;
   positioning the substrate proximate to the polytetrafluoroethylene target in a vacuum chamber at a pressure of 1.333×10⁻² Pascal to 1.333×10⁻⁴ Pascal;
   irradiating the polytetrafluoroethylene target at a wavelength of 240 nm to 360 nm for a pulse length of 100 femtosecond to 500 picoseconds, at an intensity of 1 microjoule to 100 microjoules per pulse length, at a repetition rate of from 1 kHz to 10 Hz, for a time sufficient to deposit a polytetrafluoroethylene film on the substrate;
   forming a substantially uniform polytetrafluoroethylene thin film on one more facets of the substrate wherein the film has a thickness of less than 100 nm; and
   heating the substrate for a time and temperature to bond the polytetrafluoroethylene film to the substrate surface.
Aspect 12:
   The process of aspect 11 further including the step of heating the substrate in the vacuum chamber.
Aspect 13:
   The process of aspect 11 wherein the step of irradiating the polytetrafluoroethylene target occurs at a wavelength of 244 nm to 343 nm for 100 femtoseconds to 300 femtoseconds, at an intensity of 10 microjoules to 20 kilojoules, at a repetition of 1 kHz to 500kHz.
Aspect 14:
   The process of aspect 11 wherein the step of forming a substantially uniform polytetrafluoroethylene thin film, the film has a thickness of less than 50 nm.
Aspect 15:
   A razor comprising a least one razor blade having a coating formed by the method of any preceding aspect.

### BRIEF DESCRIPTION OF THE DRAWINGS

The features of the disclosure believed to be novel and the elements characteristic of the invention are set forth with particularity in the appended claims. The figures are for illustration purposes only and are not drawn to scale. The disclosure itself, however, both as to organization and method of operation, can best be understood by reference to the description of the preferred embodiment(s) which follows, taken in conjunction with the accompanying drawings in which:
Figure 1 shows a schematic of the inventive process inside a vacuum chamber wherein a stack of razors is fixed at an angle α relative to the fluorocarbon ablation plume created from a single fluorocarbon polymer target source.
Figure 2 shows a schematic of the inventive process wherein a stack of razors is fixed relative to the fluorocarbon polymer ablation plumes created from more than one fluorocarbon polymer target source.
Figure 3 is an XPS spectrum of the fluorocarbon film comprising about 30% CF₂ deposited according to Example 1.
Figure 4 is an XPS spectra of a comparison commercial PTFE film comprising about 99% CF₂ sprayed on to a substrate using a dispersion of Chemours LW 2120 PTFE.
Figure 5 is an XPS spectrum of the film comprising about 99% CF₂ deposited onto a substrate according to Example 2.
Figure 6 is an optical image of a razor blade edge having a polytetrafluoroethylene coating deposited using the process of the present invention.
Figure 7 is an optical image of a razor blade edge having a polytetrafluoroethylene coating deposited using a convention spray method of a dispersion of Chemours LW 2120 PTFE.

### DETAILED DESCRIPTION

The embodiments of the present disclosure can comprise, consist of, and consist essentially of the features and/or steps described herein, as well as any of the additional or optional ingredients, components, steps, or limitations described herein or would otherwise be appreciated by one of skill in the art. It is to be understood that all concentrations disclosed herein are by weight percent (wt. %.) based on a total weight of the composition unless otherwise indicated. Any numerical range recited herein is intended to include all sub-ranges subsumed therein, and such ranges are understood to include each and every number and/or fraction between the stated range lower and upper values.

One broad embodiment of the invention provides a process for depositing or forming a thin fluorocarbon coating on a multi-faceted substrate, such as a razor blade having a sharp cutting edge, and in particular, a process wherein a thin fluorocarbon coating is formed on at least a portion of a cutting edge of such a substrate, which process comprises irradiating a fluorocarbon polymer such as PTFE, with pulses of laser radiation at a wavelength of 200 to 1100 nm, at 10 micro Joules to 1 Joule per pulse, wherein the length is 1 femtosecond to 10 nanoseconds, e.g., from 1 femtosecond to 1 nanosecond or from 1 femtosecond to 500 picoseconds, at a repetition rate of from 1 kHz to 1 GHz.

The polymer films formed on the substrate have a substantially uniform thickness and are thin, e.g., 500 nm or less, such as 300 nm or less, and are typically very thin, 200 nm or less, e.g., 150 nm or less, and in particular embodiments, films with thicknesses of 100 nm or less are prepared, e.g., films with a thickness of 75 nm, 50 nm, or 30 nm or less. The CF₂ content of the films is typically at least 90%, often greater than 95%, and in some embodiment greater than 99% CF₂ is achieved. The films are highly uniform and smooth, typically with high degrees of crystallinity, and generally exhibit excellent coefficients of friction compared to conventionally produced PTFE coatings presently used in the razor industry.

One embodiment of the invention thus provides a process for forming a fluorocarbon coating on a substrate having one or more cutting edges defined by a sharpened tip and adjacent facets, the process comprising positioning the substrate to be coated proximate to a fluorocarbon polymer target in a vacuum chamber and under a pressure of 1.333×10⁻¹ Pascal to 1.333×10⁻⁷, e.g., 1.333×10⁻² to 1.333×10⁻⁴ Pascal, irradiating the fluorocarbon polymer target with pulses of laser radiation at a wavelength of 300 nm to 700 nm, for example, at 343 nm, at a power of from 10 micro Joules to 1 Joule per pulse wherein the pulses have a pulse length of 1 femtosecond to 10 nanoseconds, e.g., 1 femtosecond to 1 nanosecond, or 1 femtosecond to 500 picoseconds, at a repetition rate of 1 Hz to 1 MHz for a time sufficient to deposit a film of fluorocarbon polymer of the desired thickness on all or a portion of the substrate, wherein at least the sharpened tip and a portion proximate to said sharpened tip of at least one facet of at least one cutting edge is coated by the fluorocarbon polymer.

The fluorocarbon polymer target generally comprises polytetrafluoroethylene (PTFE), widely available commercially and sold under a number of trade names, some of which include TEFLON and ZONYL from The Chemours Company; TEXOLON THP from Enpro Industries, Inc.; FLUON from Asahi Glass Company, Ltd.; AGOFLON from Solvay SA; DYNNEON from 3M; FLUROGLASS, and NORTON T-100 and T-200 from Saint Gobain SA, to name a few.

The process can be carried out at room temperature or elevated temperatures. For example, in some embodiments the fluorocarbon target is irradiated to a temperature of 20°C to 350°C, preferably 20°C to 170°C, and more preferably 150°C to 170°C.

Depending on the wavelength, pulse length, intensity and repetition rate, and the desired characteristics of the film being formed, a pulse length of 1 femtosecond to 500 picoseconds may be used to produce very thin and very smooth films. Preferably, desirable thin films can be formed using pulse lengths of 1 femtosecond to 100 picoseconds, and more preferably, 1 femtosecond to about 1 picosecond. Repetition rates from 1 Hz to about 1500 Hz may be used and certain embodiments employ repetition rates of from 5 to 100 Hz, 10 to 500 Hz, 500 to 1 MHz and 750 to 1200 Hz. The repetition rate of the laser can range from 1 kHZ to 1GHz. T

A uniform film with excellent adhesion and smoothness is often obtained without further thermal processing. However, to further improve adhesion, smooth the fluorocarbon polymer film and/or increase crystallization of the fluorocarbon polymer the coated substrate may be subject to an additional thermal processing step. For example, in some embodiments the substrate upon which the fluorocarbon polymer film has been deposited is further subjected to heating at temperatures of from about 150°C to about 450°C, e.g., about 200°C to about 400°C, or from about 250°C to about 350°C, for several minutes to several hours.

In particular embodiments of the invention, the substrate being coated is a razor blade or a substrate readily formed into a razor blade by cutting or reshaping the substrate in some way. As known in the art, often only the cutting edge of the blade is coated with the fluorocarbon coating to lower the cutting force of the razor blade edge. The invention readily allows for coating select portions of a substrate. For example, in various embodiments of the invention, just the tip of the cutting edge may be coated, the tip and one or both of the adjacent facets may be coated, and in some embodiments the tip and a portion of one or both of the adjacent facets proximate to the tip may be coated.

The invention thus provides a process for forming a thin, uniform PTFE film on one or more cutting edges of a razor blade, or if a substrate has more than one facet, a process for forming a thin, uniform PTFE film on a substrate readily formed into a razor blade, a process for forming a razor blade, a method for reducing the cutting force of a substrate such as a razor blade, and the coated substrate, e.g., the razor blade, obtained. Also provided is a razor, comprising one or more razor blades, wherein at least one razor blade is prepared according to the present invention.

One particular embodiment of the invention relates to a process for preparing a razor blade, which comprises a substrate with a cutting edge wherein at least a portion of the cutting edge is coated by the inventive process with a thin, uniform film, often less than 100 nm thick, of a fluorocarbon polymer, e.g., PTFE. While many razors presently use blades having only one exposed cutting edge, razor blades with more than one cutting edge are known and may be used in the invention. According to the present invention, razor blades having more than one cutting edges may have the fluorocarbon polymer deposited on one or more than one of the cutting edges. Some specific examples herein pertain to the formation of a coated razor blade, but one of ordinary skill in the art can readily extend the following discussion to other substrates having at least one cutting edge.

The substrate of the invention is a razor blade, or a substrate readily formed into a razor blade, comprising a substrate with a cutting edge defined by a sharpened tip and adjacent facets. A variety of materials have been used in the production of razor blades and a blade (or other substrate) comprising any such material may be used in the present invention. Often a razor blade is fashioned using steel such as stainless steel. The razor blade may also comprise layers of other hard materials deposited thereon, for example, a single or multilayered hard coating, such as amorphous diamond, chromium, chromium nitride, titanium nitride can be applied to the cutting edge.

Although layers of various thicknesses may be formed by the inventive process, e.g., from about 10 nm to about 200 nm, better comfort and cutting performance is obtained from a razor having a very thin PTFE film, e.g., less than 150 nm or 100 nm. In many embodiments of the invention, a PTFE film is deposited on at least a portion of a razor's cutting edge having a thickness of 100 nm or less, and most preferably less than 100 nm, e.g., 75 nm, 50 nm, 45 nm, or 30 nm or less.

The pulsed laser deposition process of the invention provides PTFE films having a CF₂ content of 90% or more, often 95% or more, and even 99% is achieved, which properties have not been achieved with other vacuum techniques, such as, plasma enhanced chemical vapor deposition (PECVD), radio frequency magnetron sputtering, and the like. In particular, the CF₂ content of the films deposited on a razor blade of the present invention will be equivalent to or better than the current PTFE coatings used in the razor industry prepared using, for example, DRYFILM LW2120 PTFE available from The Chemours Company, which is generally applied as a dispersion, typically by spraying, followed by heating at high temperatures.

Pulsed laser deposition of PTFE can be achieved with sufficient power at wavelengths from the near infrared to deep ultraviolet, i.e. 193 nm to 1064 nm. However, high peak power infrared femtosecond pulses have been shown to break the carbon chains and decompose the target polymer. Lower peak power ultraviolet nanosecond pulses preserve the carbon chains and original material characteristics, but nanosecond pulsed laser deposition often produces films with excess macroparticles, which are detrimental to the film properties generally desired, and very thin PTFE films such as those about 30nm thick are not readily formed due to agglomeration of the macroparticles. The present invention finds that picosecond pulsed ultra violet lasers can provide a balance between deposited film qualities and material characteristics needed for low friction coatings on razor blades.

In the present process, the laser ablates a target comprising of fluorocarbon polymer as a PTFE plaque, block, disk, cylinder, granules, etc., under vacuum. One or more targets may be used during the ablation. Ablation of the PTFE target occurs creating an ablation plume, and a film of the ablated PTFE forms on a substrate positioned nearby. The manner in which the substrate is positioned relative to the target will determine where on the substrate the film is deposited. Having one or more targets may successfully form desired films on one or more facets of the substrate. Preferably, the target is placed proximate to the substrate, for example, 50 mm to 100 mm, although one of skill in the art can determine the optimum distance between the target and the substrate to produce the desired film formation. The fluorocarbon target typically comprises a PTFE having a mole average molecular weight of from 3,000 to 4,000,000. For example, many embodiments employ a target comprising a PTFE with a mole average molecular weight of from 3,000 to 2,000,000, for example from 4,000 to 400,000 or from 4,000 to 100,000, such as from 100,000 to 400,000 or from 10,000 to 50,000. In other embodiments, the target comprises a PTFE with a mole average molecular weight of from 400,000 to 4,000,000, for example from 500,000 or 1,000,000 to 4,000,000, from 2,000,000 to 4,000,000.

The fluorocarbon polymer target may be a single component, a blend of PTFE with another substance, or it may comprise a fluoropolymer supported by another substance, such as a non-fluorocarbon cylinder supporting an outer layer of the target fluorocarbon polymer. The fluorocarbon polymer target may be doped with a material to enhance absorption at the desired wavelength. For example, the fluorocarbon polymer may be doped with graphite, an organic dye, or other metals such as tin. A preferred dopant is graphite in an amount of up to 2 wt. % graphite, up to 1.5 wt. % graphite, up to 0.5 wt. % graphite, up to 0.2 wt. % graphite, or up to 0.05 wt. % graphite.

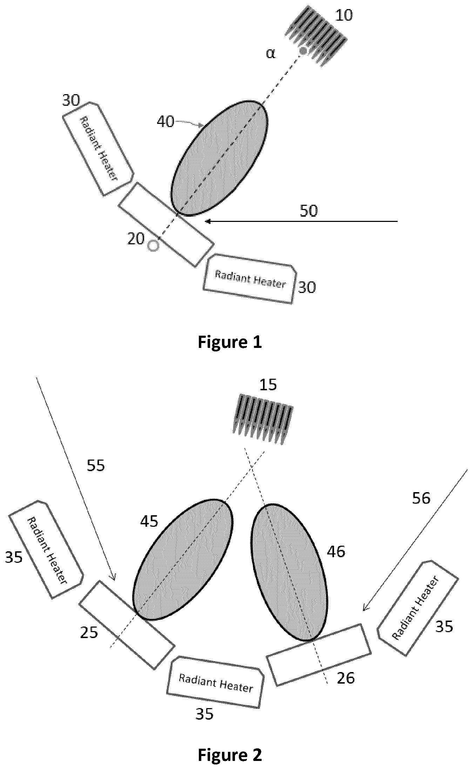

In general, the pulsed laser deposition process of the invention is carried out in a vacuum chamber. The plume expansion in vacuum is considered adiabatic, as long as there is no mass and energy transfer to the ablation plume and hence the plume expansion is called almost collision free. In Fig. 1, inside the reaction chamber (not shown), substrate 10 comprising one or more razor blades (although a stack is shown), is typically positioned in the vacuum at an angle α equal to 25° up to 90°, to the target 20 comprising a fluorocarbon polymer such as PTFE. The target 20 can be heated with radiant heaters 30. A laser source, not shown, projects light 50 at wavelengths of 200 nm to 1000 nm. When the laser 50 hits the target 10, an ablation plume 40 of target material is formed, which upon contact with a surface of substrate 10, deposits a film of target material on substrate 10 or a portion thereof.

In Fig. 2, inside the reaction chamber, a substrate 15 comprising one or more razor blades is positioned in the reaction chamber proximate to a first fluorocarbon polymer target 25 and a second fluorocarbon polymer target 26. The targets 25/26 can be heated with one or more radiant heaters 35. A first laser source 55 and a second laser source 56, not shown, projects light 55/56 at wavelengths as disclosed above to form an ablation plume 45/46 of each target material, which upon contact with the surface of substrate 15, deposits a film of target material 40 onto the surface thereof. Additional targets and the ablation plumes created therefrom allow deposition at multiple angles to coat the multiple facets of a substrate such as a razor blade with a cutting edge.

The type of laser may include, but is not limited to, any third or fourth harmonic of a Nd:YAG, Yb:YAG, or Nd:YLF type laser, any picosecond pulsed laser in the excimer family of lasers, XeCl, ArF, KrF, F2, and the like. The pulse length is typically from 1 femtosecond to about 200 picoseconds. Films can be formed using longer pulse lengths, e.g., 10 nanoseconds, but high quality films less than 100 nm or 50 nm thick are not usually obtained with these longer pulses. The repetition rate is from 1 kHz to 1 GHz and the intensity of the laser at 20 microjoules to 1 Joule/pulse. The target typically comprises PTFE, an example of which is TEXOLON THP 8764, but other PTFE sources can be used. In order to help the growth of a thin, contiguous, uniform PTFE film, heaters can be employed to maintain a selected temperature of the substrate during deposition. However, heaters are not always necessary and temperatures from 0°C, 10°C or 20°C to 200°C, 250°C, or 350°C may be employed.

Post thermal processing may be required to both smooth the film and increase crystallization. This may be accomplished either above or below the melt temperature of the fluorocarbon polymer. Heating above the melt temperature of the fluorocarbon polymer may be required to ensure good adhesion of the polymer to the substrate. Typical temperatures include, but are not limited to, the range of 250°C to 350°C for several minutes to several hours. In some embodiments, this thermal treatment step is not necessary or optional.

Generally speaking, the substrate to be coated according to the invention may be of any overall shape and be made of any material that is hard enough to hold a sharpened edge and is stable to the processing conditions employed. Such substrate materials include metals; metal alloys such as stainless steel; metal compounds such as metal carbides and nitrides; ceramics or hardened clay; a hard carbon substrate; and even some organic polymers. The substrate may be made from a single material or multiple materials and may be formed as a single integrated mass or comprise various layers.

The present process is ideally suited to forming a PTFE film on the cutting edge of a substrate, and whereas the entire substrate can be coated according to the invention, it is usually more cost effective to limit the coating to the cutting edge itself, or even a portion of the cutting edge. As discussed above, the substrate of the invention may comprise one or more than one cutting edges, and a film according to the invention may be deposited on one or more than one of these cutting edges.

As recognized in the art, a cutting edge is often defined by a sharpened tip and adjacent facets. Razor blades often have a cutting edge having a sharpened tip of radius less than 1000 Angstroms, and preferably 200 to 500 Angstroms. The facets adjacent to sharpened tip typically have an included angle less than 30 degrees, e.g., about 15 to 20 degrees, measured 40 microns from the sharpened tip. The facets can be viewed as providing different faces of the cutting edge. In some embodiments of the invention a film is formed on one of these faces, in other embodiments a film is formed on both faces. The deposited film may cover the entire facet from the tip to the point at which the facet contacts the rest of the substrate, but in some embodiments, only a portion of the facet proximate to the tip is coated.

The laser pulse parameters, such as wavelength, pulse length and frequency, power per pulse, can all play a significant role in the characteristics of the film that is formed on the substrate. In various specific embodiments, the laser wavelengths are from 190 to 500nm, e.g., from 300 nm to 450 nm, and may include 323 nm to 400 nm. Alternatively, the laser wavelengths may include 300 nm to about 750 nm, e.g., from about 500 nm to about 700 nm, and in some specific embodiments the wavelengths were from about 700 nm to about 1075 nm, e.g., from about 750 nm to about 1064 nm.

The pulse lengths may vary depending on the other parameters and 1 femtosecond to 100 picoseconds pulses are used, preferably 1 femtosecond to 10 picosecond, and more preferably, 1 femtosecond to 1 picosecond pulses.

The power per pulse ranges from 10 kilojoules to 1 micro Joules, e.g., from 20 kilojoules to 500 kilojoules, in some specific embodiments the power per pulse ranges from 500 kilojoules to about 1 Joule, e.g., from 700 kilojoules to 500 micro Joules or from 1 or 50 micro Joules to 250 to 500 micro Joules.

### EXAMPLES

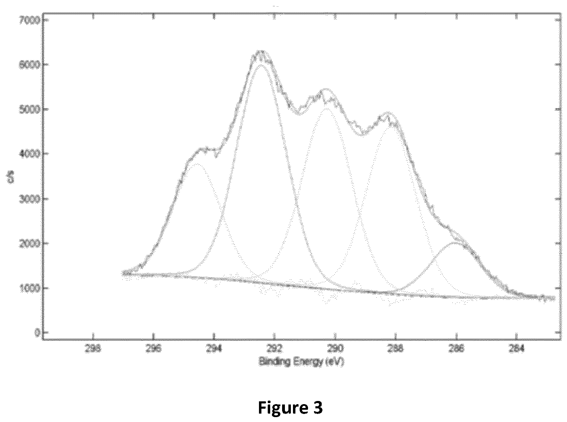

Example 1 is a film made using a conventional RF magnetron sputtering technique. A razor blade was fixtured inside a vacuum chamber in front of a PTFE target with a throw distance of 65mm. The chamber was pumped down to a base pressure of 6.666×10⁻³ Pascal. A background gas of argon was bled into the chamber such that the pressure was 1.866 Pascal. The magnetron power was set to 213 Watts and a PTFE film having a thickness of 100 nm was formed on the blade. Figure 3 shows the X-ray photon (XPS) spectra of the film of Example 1 comprising about 30% CF₂. The multiple peaks are redolent of multiple chemical species found in the film.

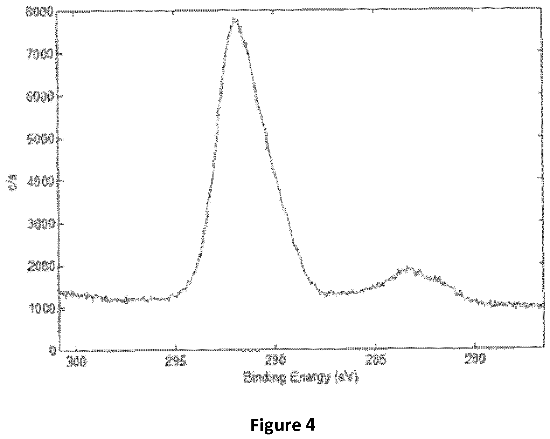

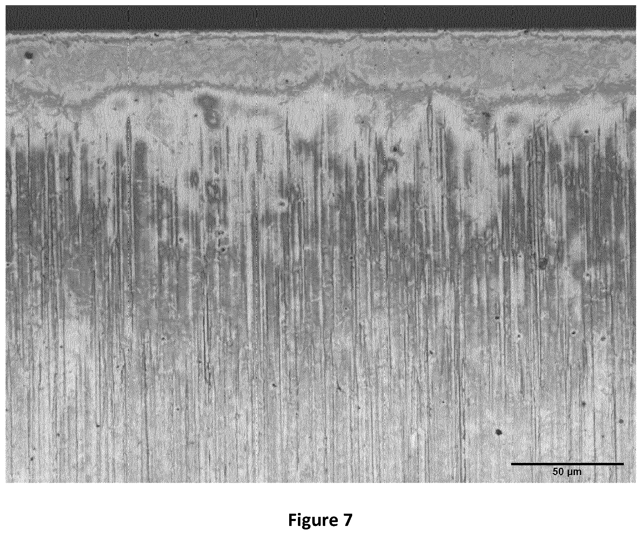

Figure 4 shows the XPS spectra of a commercially available PTFE film comprising about 99% CF₂, which was sprayed on to the blades using a dispersion of DRYFILM LW2120 PTFE available from The Chemours Company. In comparison to the RF magnetron sputtered film, the sprayed film shows the sprayed film comprising predominantly a single chemical species, CF₂. However, the sprayed coating is not smooth with high points and low points with thicknesses ranging from 300 nm to 700 nm thick. This can be seen on the optical image in Figure 7 where the top of the image shows a variation in the topography of the coating.

Example 2 is an example of pulsed laser deposition using a nanosecond KrF excimer laser at a wavelength 248nm. A razor blade was fixtured inside a vacuum chamber in front of a PTFE target with a throw distance of 100 mm. The chamber was pumped down to a base pressure of 6.666×10⁻³ Pascal. With the blade at room temperature, the target was irradiated with pulses at an intensity of 250 millijoules per pulse, a pulse length of 25 nanoseconds and a repetition rate of 50Hz.

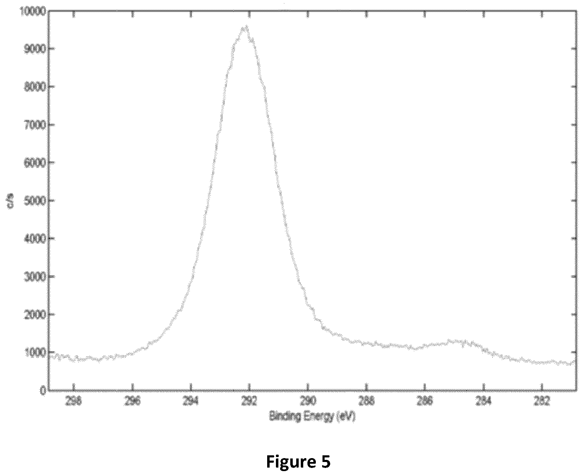

Figure 5 shows an XPS spectrum of Example 2 wherein the film deposited onto the razor comprises about 99% CF₂, which is similar to the XPS spectrum of the commercially available PTFE film from the dispersion of Chemours LW 2120 of Figure 4. However, under the PLD conditions of Example 2, the thickness of the film is an undesirable 1000 nm. The high intensity and long pulse length created macroparticles that prevented the formation of a film having a uniform thickness below 100nm.

In accordance with the present invention, Example 3 utilized pulsed laser deposition with femtosecond pulses using a Ti:Sapphire laser at a wavelength of 800 nm, at an intensity of 100 micro Joules per pulse, with a pulse length of 120 femtoseconds, at a repetition rate of 1kHz. The fluorocarbon polymer target was PTFE. The throw distance was 75 mm. A uniform thin film having a thickness of 30 nm was deposited onto the substrate.

In accordance with the present invention, Example 4 utilized pulsed laser deposition with femtosecond pulses using a Yb:YAG laser at a wavelength of 343 nm, at an intensity of 10 microjoules per pulse, with a pulse length of 300 femtoseconds, at a repetition rate of 500 kHz. The fluorocarbon polymer target was PTFE doped with 0.2 wt. % graphite. The throw distance was 89 mm. A uniform thin film having a thickness of 33 nm was deposited onto the substrate.

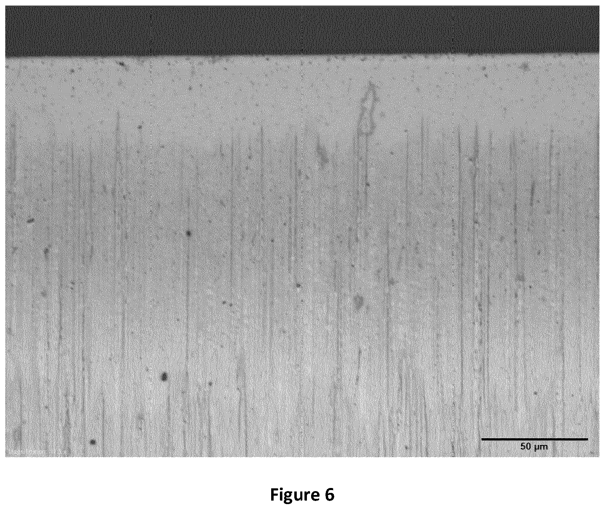

Figure 6 is an optical image showing the uniformity of the film formed in Example 4 wherein the edge of the razor blade is shown at the top of the image. Contrast this with the optical image of a conventional PTFE film formed by spraying a dispersion of DRYFILM LW2120 PTFE followed by heating shown in Figure 7.

The present invention discloses a method for forming uniform thin films on multi-faceted substrates utilizing pulsed laser deposition by optimizing wavelength, intensity, pulse length, and repetition rate. Uniform thin films of a fluorocarbon polymer can be formed when irradiating a fluorocarbon polymer target to produce films having a preferred thickness of less than 100 nm, more preferred thickness of less than 50 nm, and a most preferred thickness of less than 40 nm on one or more facets of the substrates. Such deposition methods are particularly useful in forming uniform thin polytetrafluoroethylene films on the cutting edges of razor blades to lower the cutting force of the blade.

While the present disclosure has been particularly described, in conjunction with specific preferred embodiments, it is evident that many alternatives, modifications and variations will be apparent to those skilled in the art in light of the foregoing description. It is therefore contemplated that the appended claims will embrace any such alternatives, modifications and variations as falling within the true scope of the present disclosure.

## Claims

1. A process for forming a thin film of polytetrafluoroethylene on a substrate having multiple facets comprising the steps of:
providing a polytetrafluoroethylene target, said target doped with graphite;
positioning the substrate proximate to the polytetrafluoroethylene target in a vacuum chamber at a pressure of 1.333×10⁻² Pascal to 1.333×10⁻⁴ Pascal;
irradiating the polytetrafluoroethylene target at a wavelength of 240 nm to 360 nm for a pulse length of 100 femtosecond to 500 picoseconds, at an intensity of 1 microjoule to 100 microjoules per pulse length, at a repetition rate of from 1 kHz to 10 Hz, for a time sufficient to deposit a polytetrafluoroethylene film on the substrate;
forming a substantially uniform polytetrafluoroethylene thin film on one more facets of the substrate wherein the film has a thickness of less than 100 nm; and
heating the substrate for a time and temperature to bond the polytetrafluoroethylene film to the substrate surface.

2. The process of claim 1 further including the step of heating the substrate in the vacuum chamber.

3. The process of claim 1 wherein the step of irradiating the polytetrafluoroethylene target occurs at a wavelength of 244 nm to 343 nm for 100 femtoseconds to 300 femtoseconds, at an intensity of 10 microjoules to 20 kilojoules, at a repetition of 1 kHz to 500 kHz.

4. The process of claim 1 wherein the step of forming a substantially uniform polytetrafluoroethylene thin film, the film has a thickness of less than 50 nm.

5. The process according to any preceding claim further including the step of heating the substrate up to a temperature of 170° C.

6. The process according to claim 1 wherein in the step of forming the substantially uniform thin film of polytetrafluoroethylene, the thin film of polytetrafluoroethylene has a thickness of 10 nm to 100 nm.

7. The process according to any preceding claim further including the step of thermally processing the coated substrate after the step of forming the substantially uniform thin film of polytetrafluoroethylene.

8. The process according to claim 7 wherein the step of thermally processing the coated substrate comprises heating the substrate at temperatures of from 250 to 350° C for several minutes.

9. The process according to any preceding wherein the target is positioned within the vacuum chamber at an angle α equal to 25° up to 90°.

10. The process according to any preceding claim wherein the target is doped with graphite in an amount of up to 2 wt. %.

11. The process according to any preceding claim wherein the target is doped with, in addition to graphite, an organic dye or other metals such as tin.

12. The process according to any preceding claim wherein the thin film of polytetrafluoroethylene includes a CF2 content of 90 % or more.

13. The process according to claim 12 wherein the thin film of polytetrafluoroethylene includes a CF2 content of 95 % or more.

14. The process according to claim 13 wherein the thin film of polytetrafluoroethylene includes a CF2 content of 99 % or more.

15. A razor comprising a least one razor blade having a coating formed by the method of any preceding claim.
